# FASCICULE DE BREVET EUROPEEN

(11) **EP 2 464 006 B1**
(45) Date de publication et mention de la délivrance du brevet: **30.05.2018**
(21) Numéro de dépôt: 11191911.4
(22) Date de dépôt: 05.12.2011
(51) Int. Cl.: H03H 3/02, H03H 9/17

(54) **Procédé de fabrication d'un résonateur à ondes acoustiques comprenant une membrane suspendue**
Herstellungsverfahren eines Schallwellenresonators, der eine aufgehängte Membran umfasst
Method for manufacturing an acoustic-wave resonator including a suspended membrane

(30) Priorité: 10.12.2010 FR 1060358
(43) Date de publication de la demande: 13.06.2012
(73) Titulaire: Commissariat à l'Énergie Atomique et aux Énergies Alternatives, 75015 Paris (FR)
(72) Inventeur: Imbert, Bruno, 38000 Grenoble (FR); Defay, Emmanuel, 38340 Voreppe (FR); Deguet, Chrystel, 38330 Saint Ismier (FR); Moriceau, Hubert, 38120 Saint-Egreve (FR); Pijolat, Mathieu, 42290 Sorbiers (FR)
(74) Mandataire: Esselin, Sophie

(56) Documents cités:
- US-A1- 2003 199 105
- US-A1- 2005 255 234
- TONG Q-Y ET AL: "Semiconductor wafer bonding: recent developments", MATERIALS CHEMISTRY AND PHYSICS, ELSEVIER, vol. 37, no. 2, 1 mars 1994 (1994-03-01), pages 101-127, XP024148341,
- PIJOLAT M ET AL: "Large electromechanical coupling factor film bulk acoustic resonator with X-cut LiNbO3 layer transfer", APPLIED PHYSICS LETTERS, AIP, vol. 95, no. 18, 5 novembre 2009 (2009-11-05), pages 182106-182106, XP012126324,

## Description

Le domaine de l'invention est celui des filtres à résonateurs à ondes acoustiques. Le développement des télécommunications radiofréquences depuis une dizaine d'années se traduit par un encombrement des bandes de fréquence autorisées. Pour profiter des plages de fréquence disponibles, les systèmes doivent inclure un filtrage de bande, avec une bande de transition étroite. Seuls les filtres à résonateurs en technologie SAW (ondes de surface) ou BAW (ondes de volume), utilisant les propriétés piézoélectriques des matériaux, permettent de tenir ces spécifications avec de faibles pertes et un encombrement réduit. Aujourd'hui, les couches piézoélectriques utilisées pour ces filtres sont réalisées par dépôt (filtres BAW « Bulk Acoustic Wave ») ou à partir de substrats massifs (filtres SAW « Surface Acoustic Wave »).

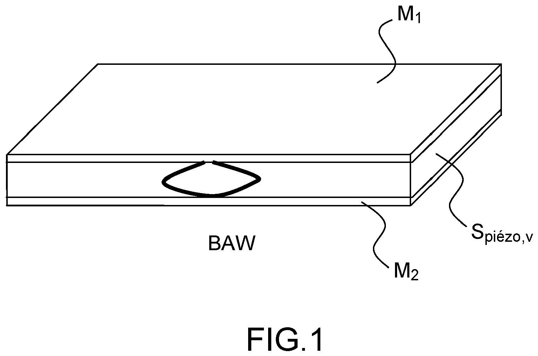

De manière générale, le principe de fonctionnement des composants BAW est illustré en figure 1 qui montre une structure de filtre à ondes de volume : un substrat piézoélectrique S_{piézo, v} est inséré entre deux métallisations M₁ et M₂ permettant la propagation d'ondes de volume.

Les articles suivants retracent une synthèse complète des filtres à base de résonateurs de type BAW et SAW : W. Steichen, S. Ballandras, "Composants acoustiques utilisés pour le filtrage : revues de différentes technologies", Editions de Techniques de l'Ingénieur, E-2000, 31 pages, 2008 ; R. Aigner, Bringing BAW technology into volume production : the Ten Commandments and the seven deadly sins, Proceedings of the third international symposium on acoustic wave devices for future mobile communication systems (2007). J. Kaitila : Review of wave propagation in BAW thin film devices: progress and prospects, Proceedings of the 2007 IEEE Ultrasonics Symposium. P. Murait et al. : Ils there a better material for thin film BAW applications than AIN, Proceedings of the 2005 IEEE Ultrasonics Symposium.

Les filtres à ondes de volume existent depuis des dizaines d'années à des fréquences de quelques MHz à quelques dizaines de MHz, utilisant principalement des éléments d'impédance ou des structures à couplage latéral sur quartz pour des applications à bandes étroites, mais leur mise en oeuvre aux radiofréquences ne date que d'une dizaine d'années, suite aux travaux pionniers de Lakin sur l'utilisation de couches piézoélectriques déposées par pulvérisation cathodique à de telles fins. La société Agilent dont la branche « filtre FBAR » (Film Bulk Acoustic Resonator) a donné lieu à la spin-off AVAGO, a été la première à développer un filtre RF à base d'éléments d'impédance tirant parti de films minces de nitrure d'aluminium (AIN), matériau polycristallin déposé. Suite à ces avancées techniques, un grand nombre de chercheurs académiques et industriels se sont lancés sur cette piste, donnant lieu à une activité inventive soutenue durant la présente décennie.

De manière générale, les résonateurs BAW exploitent la résonance en épaisseur d'une couche piézoélectrique mince qui est isolée acoustiquement du substrat soit par une membrane (technologie FBAR utilisée par AVAGO Technologies), soit par un réseau de Bragg (technologie SMR utilisée par Infineon). Le matériau le plus employé en technologie BAW est à l'heure actuelle le Nitrure d'Aluminium (AIN), qui présente l'avantage d'avoir des coefficients de couplage piézoélectrique de l'ordre de 6.5 %, et également d'avoir de faibles pertes acoustiques et diélectriques, ce qui permet la synthèse de filtres présentant des bandes passantes compatibles avec les spécifications réclamées par la plupart des standards de télécommunication localisés entre 2 et 4 GHz.

Néanmoins, plusieurs problèmes continuent à se poser face aux spécifications extrêmement contraignantes présentées par quelques bandes de fréquences, telles que le standard DCS.

Tout d'abord, les coefficients de couplage piézoélectrique permis par l'AIN n'autorisent pas des bandes passantes relatives supérieures à 6 %. De telles largeurs de bande nécessitent déjà l'utilisation d'électrodes présentant une très forte impédance acoustique (en Molybdène ou en Tungstène), de manière à confiner l'énergie élastique dans la couche piézoélectrique, et des épaisseurs soigneusement déterminées de manière à maximiser leur influence sur le coefficient de couplage piézoélectrique des résonateurs, comme décrits dans les articles suivants : R. Aigner, Bringing BAW technology into volume production: the Ten Commandments and the seven deadly sins, Proceedings of the third international symposium on acoustic wave devices for future mobile communication systems (2007) ; J. Kaitila, Review of wave propagation in BAW thin film devices: progress and prospects, Proceedings of the 2007 IEEE Ultrasonics Symposium. Il n'existe à l'heure actuelle pas de solutions crédibles pour l'extension de cette bande relative à pertes constantes.

Des recherches sont menées pour trouver d'autres matériaux présentant des coefficients de couplage piézoélectrique plus élevés, mais force est de constater qu'il n'existe pas d'autre matériau proposant de faibles pertes acoustiques et que l'on sache déposer de manière reproductible et uniforme, comme décrit dans l'article : P. Murait et al., Is there a better material for thin film BAW applications than AIN, Proceedings of the 2005 IEEE Ultrasonics Symposium.

A l'inverse, des matériaux monocristallins tels que le Niobate de Lithium ou le Tantalate de Lithium proposent des coefficients de couplages électromécaniques très élevés, permettant la réalisation de filtres présentant des largeurs de bandes relatives de l'ordre de 50 % ;

Ensuite, les standards tels que le DCS nécessitent également à la fois une large bande passante et une forte réjection des standards adjacents. Répondre simultanément à ces deux contraintes nécessite d'utiliser des résonateurs possédant de très forts coefficients de qualité. Bien des travaux ont été menés dans les dix dernières années pour améliorer les propriétés de confinement des ondes acoustiques des résonateurs (J. Kaitila, Review of wave propagation in BAW thin film devices: progress and prospects, Proceedings of the 2007 IEEE Ultrasonics Symposium). De ce fait, les limites imposées par les matériaux eux-mêmes, plus que par la structure, commencent à se profiler, et il est fort probable que des matériaux poly-cristallins ne puissent à terme plus répondre à la montée en coefficients de qualité, surtout face à la montée en fréquence des standards vers les 10 GHz. Avec des coefficients de qualité intrinsèques de l'ordre de la dizaine de milliers à des fréquences supérieures à 1 GHz : D. Gachon et al., Filters using high overtone bulk acoustic resonators on thinned single-crystal piezoelectric layer, présenté au 2008 European Frequency and Time Forum, les matériaux monocristallins se présentent là encore comme une solution intéressante.

Concernant les résonateurs de type FBAR, Campanella et al. ont réalisé un résonateur FBAR, à partir d'une membrane de nitrure d'Aluminium (AIN) déposée sur une électrode métallique platine/titane. Le substrat utilisé, sur lequel repose ces couches, est du silicium qui a été gravé par plasma réactif (RIE) pour former une cavité. (H. Campanella, J. Esteve, E. Martincic, P. nouet, A. Uranga, N. Barniol, IEEE SENSORS 2008).

Les auteurs Pijolat et al. ont montré la réalisation de tels résonateurs à partir du transfert d'un film mince de LiNbO₃ sur substrat silicium grâce un procédé basé sur du collage direct et de l'amincissement mécanique (M. Pijolat, S. Loubriat, S. Queste, D. Mercier, A. Reinhardt, E. Defaÿ, C. Deguet, L. Clavelier, H. Moriceau, M. Aïd, and S. Ballandras, Appl. Phys. Lett 95 (2009) 182106).

D'autres auteurs ont proposé de fabriquer une structure FBAR avec une couche de LiNbO₃ suspendue et dont des caractérisations électriques à 200MHz ont été réalisées : Y. Osugi, T. Yoshino, K. Suzuki and T. Hirai, IEEE 2007. Bien que la non-uniformité de l'épaisseur sur la plaque ait un effet négatif sur le facteur de qualité Q, la couche transférée de LiNbO₃ possède un facteur de couplage Kt² proche de celui du substrat massif.

D'autres types de résonateurs (y compris des résonateurs SAW) sont avantageusement réalisés sur des membranes suspendues.

Actuellement, il a déjà été proposé deux principales techniques de report de couches minces : une technique basée sur l'implantation d'ions légers (typiquement hydrogène) et la fracture au niveau de la zone implantée, et la technique précédemment évoquée basée sur un collage et un amincissement mécanique. Ces techniques permettent de reporter une couche monocristalline sur un substrat hôte. Ces techniques sont parfaitement maîtrisées sur silicium permettant entre autres la fabrication industrielle de plaquettes SOI (Silicon On Insulator).

Le procédé de report par implantation/fracture est notamment décrit dans l'article de M. Bruel : "Silicon on insulator material technology", Electronic letters, 31 (14), p1201-1202 (1995), il permet la réalisation de substrats SOI « Silicon On Insulator » correspondant à du silicium sur isolant.

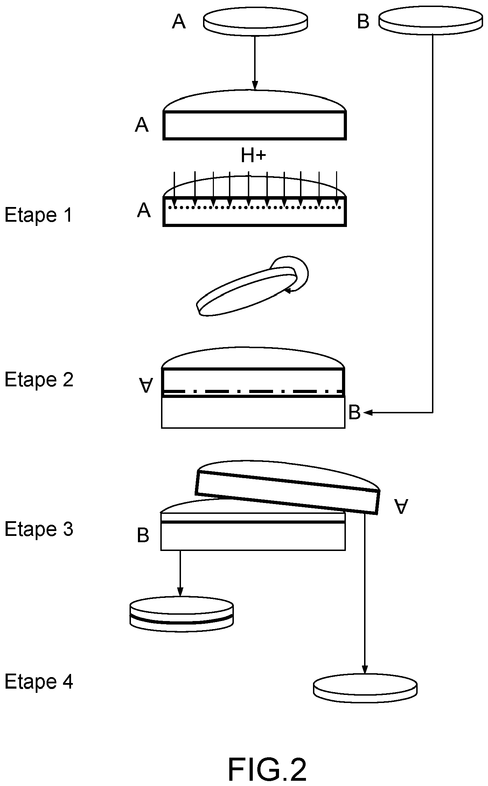

Ce procédé peut être schématiquement résumé par les quatre étapes suivantes illustrées en figure 2 :
Etape 1 : Un substrat donneur A, par exemple de silicium est implanté par des espèces gazeuses (par exemple de l'hydrogène et/ou des gaz rares) pour former une zone fragile enterrée, délimitant dans ce substrat le film mince à transférer.
Etape 2 : Le substrat donneur est ensuite assemblé au niveau du film mince précédemment défini, par exemple par collage direct (encore appelé collage moléculaire), avec un substrat de réception B.
Etape 3 : Une étape de fracture est ensuite obtenue au niveau de la zone fragile enterrée au moyen d'un traitement thermique éventuellement assisté de l'application de contraintes mécaniques. On obtient alors d'une part le film mince solidaire du substrat de réception, et d'autre part le reliquat du substrat donneur correspondant au substrat donneur initial A, pelé du film mince transféré. Ce dernier peut alors être recyclé pour la réalisation d'un autre transfert.
Etape 4 : Eventuellement, des traitements finaux peuvent être réalisés, par exemple un recuit à haute température pour consolider l'interface de collage entre le film mince transféré et le substrat de réception

L'épaisseur du film mince transféré est directement reliée à l'énergie d'implantation du faisceau d'ions. A titre d'exemple, l'épaisseur de silicium transférée peut aller de quelques dizaines de nanomètres à quelques micromètres en utilisant un implanteur conventionnel (pour lequel l'énergie d'implantation est typiquement inférieure à 250keV).

Les couches transférées sont uniformes et homogènes en épaisseur car définies par une profondeur d'implantation et non par un amincissement mécanique.

Le document EP0741910 propose de réaliser un report de film mince sur un substrat pourvu de cavités. Les cavités sont réalisées par photolithographie et gravure avant l'étape de collage, ce qui rajoute donc au procédé précédemment décrit une étape coûteuse. Par ailleurs, les dimensions accessibles pour la cavité sont limitées du fait du procédé.

Le document EP0851465 propose de décoller localement une membrane de son support par implantation au niveau de l'interface de collage. La zone de forte implantation (autour de l'interface de collage) subit dans ce cas un endommagement important pouvant entrainer localement une modification des propriétés du matériau.

Alors qu'aujourd'hui dans la majorité des composants pour les MEMS « Micro-Electro-Mechanical Systems », les couches de matériaux piézoélectriques sont réalisées par des techniques de dépôts de type PVD « Plasma Vapor Déposition » et que les couches à élaborer pour ces composants présentent des épaisseurs dans une gamme d'épaisseurs comprises entre quelques centaines de nanomètres et le micromètre, la maîtrise de la fabrication de couches piézoélectriques et électrostrictives monocristallines pour cette gamme d'épaisseurs constitue un verrou technologique important.

Dans ce contexte, la présente invention a pour objet un procédé innovant de fabrication d'un résonateur à ondes acoustiques de volume comprenant une membrane comportant une fine couche de matériau piézoélectrique.

Plus précisément l'invention concerne un procédé de fabrication d'un résonateur à ondes acoustiques comprenant une membrane suspendue comportant une couche de matériau piézoélectrique, caractérisé en ce qu'il comprend les étapes suivantes :
- la réalisation d'un premier empilement comportant au moins une couche de premier matériau piézoélectrique à la surface d'un premier substrat ;
- la réalisation d'un second empilement comprenant au moins un second substrat ;
- la réalisation d'au moins une zone initiatrice de non collage par dépôt ou création de particules de tailles maîtrisées laissant la surface d'un desdits empilements dotée localement de nanostructures en saillie avant une étape subséquente de collage ;
- le collage direct desdits deux empilements créant une cloque entre les empilements, due à la présence de la zone initiatrice de non collage ;
- l'amincissement du premier empilement pour éliminer au moins le premier substrat.

Par collage direct, on entend tout type de collage ne nécessitant pas la présence d'une substance adhésive. Il peut s'agir avantageusement d'un collage par contact direct mais il peut s'agir également d'un collage par thermocompression ou d'un collage anodique ou encore d'un collage par fusion (« fusion bonding » en anglais).

La zone initiatrice de non collage a ainsi pour but d'empêcher localement le collage entre les deux empilements à son endroit ou son voisinage, générant ainsi une cloque entre la couche de premier matériau piézoélectrique et le second empilement, permettant le découplage acoustique local de ces deux éléments.

Les nanostructures ont des dimensions latérales (dans le plan du substrat) inférieures à 1 micron et avantageusement comprise entre 10 et 100 nm.

L'invention permet ainsi de réaliser des membranes suspendues collectivement sur une plaque (wafer en anglais) avec des dimensions latérales allant de 100 microns au millimètre.

Avantageusement, une étape de traitement thermique peut être réalisée pendant ou après l'étape de collage direct afin de favoriser la création et/ou la croissance de la cloque. Typiquement, ce traitement thermique peut avoir lieu à une température comprise entre 100°C et 500°C. Cette étape peut également permettre à deux ou plusieurs cloques contigües de se rejoindre pour former une cloque de dimension supérieure.

La zone initiatrice de non collage peut être une nanostructure en saillie c'est-à-dire une excroissance locale par rapport à la surface de dimensions submicroniques. La cloque générée s'étend alors de part et d'autres de cette nanostructure.

Selon une variante de l'invention, l'étape de réalisation de cette nanostructure en saillie est effectuée par lithographie et gravure.

Selon une variante de l'invention, l'étape de réalisation de cette nanostructure en saillie est effectuée par le dépôt de particules de taille contrôlée et de manière localisée.

Selon une variante de l'invention, la nanostructure en saillie présentant une hauteur de l'ordre de quelques dizaines à quelques centaines de nanomètres, la cloque présente une étendue de diamètre de l'ordre d'un millier de micromètres.

Il est à noter que le traitement thermique réalisé pendant ou après l'étape de collage, peut permettre également de décoller localement la surface de la nanostructure en saillie de la surface de l'empilement en regard.

De même, la surface entourant la nanostructure en saillie ou celle en regard de celle-ci peut avoir été préparée préalablement au collage pour faciliter ou pour adapter l'extension de la cloque lors du traitement thermique par exemple.

Cette préparation peut notamment consister à diminuer l'hydrophilie et/ou à augmenter la rugosité de la surface si l'on souhaite favoriser l'extension latérale de la cloque et réciproquement.

Pour modifier l'hydrophilie, on peut avoir recours par exemple à un traitement plasma ou UV/ozone. Pour modifier la rugosité, on peut avoir recours par exemple à une gravure chimique, humide ou sèche.

Selon une variante de l'invention, la zone initiatrice de non collage est obtenue par le dépôt localisé d'hydrocarbures ou de produits liquides ou solides pouvant générer des sous-produits gazeux, par exemple à l'aide d'une pointe de microscope à force atomique (AFM). Cette zone crée une zone de non collage ou cloque qui peut être appelée à croitre en dimension par effet de pression dans la zone non collée suite à un traitement thermique.

Avantageusement, le premier empilement et/ou le second empilement peuvent comporter en surface une couche de collage, au niveau de laquelle le collage direct est effectué.

Avantageusement, le premier empilement peut comporter entre la couche de premier matériau piézoélectrique et l'éventuelle couche de collage (ou la surface) une couche métallique destinée à servir d'électrode.

Avantageusement, le premier matériau piézoélectrique est monocristallin. Une telle couche peut être obtenue par épitaxie sur un substrat adapté ou constituée la partie superficielle du premier substrat. Dans ce cas, le premier substrat peut être un substrat massif du premier matériau piézoélectrique. La couche peut également être déposée sur le premier substrat.

Selon une variante de l'invention, le procédé comporte en outre une étape d'implantation ionique de manière à créer dans le premier empilement une zone fragile enterrée délimitant avec la surface dudit empilement une zone comportant au moins en partie la couche de premier matériau piézoélectrique.

Selon cette variante de l'invention, l'amincissement est alors obtenu par fracture au niveau de la zone fragile enterrée.

Selon une autre variante de l'invention, l'amincissement est obtenu par meulage (« grinding » en anglais) et polissage.

Avantageusement, l'étape de polissage est une étape de polissage mécano-chimique (plus connu sous l'acronyme CMP (chemical and mechanical polishing)). Ce polissage est réalisé par exemple à l'aide d'une solution contenant un abrasif (« slurry » en anglais), par exemple à base de silice colloïdale.

Selon une variante de l'invention, le matériau piézoélectrique est en LiNbO₃ ou en LiTaO₃ ou plus généralement en Li(TaxNb1-x)03. Si la couche est déposée, le matériau piézoélectrique peut être en AIN ou PZT notamment.

Selon une variante de l'invention, le second substrat est en silicium ou en quartz ou en diamant ou encore en saphir. Il peut être simple ou composite.

Selon une variante de l'invention, au moins une couche de collage est en matériau diélectrique pouvant être en SiO₂.

Selon une variante de l'invention, le procédé comprend en outre une étape de définition d'électrode dans ladite couche métallique.

Selon une variante de l'invention, le procédé comprend en outre une étape de réalisation d'une électrode supérieure à la surface de l'empilement final des premier et second empilements après l'étape d'amincissement.

L'invention sera mieux comprise et d'autres avantages apparaîtront à la lecture de la description qui va suivre et grâce aux figures annexées parmi lesquelles :
- la figure 1 illustre le principe de fonctionnement des composants BAW mettant en évidence la propagation des ondes acoustiques de volume ;
- la figure 2 illustre les différentes étapes d'un procédé de report de substrats par implantation/fracture selon l'art connu ;
- les figures 3a à 3e illustrent les différentes étapes d'un exemple de procédé de fabrication d'un résonateur de type FBAR selon l'invention ;
- les figures 4a et 4b schématisent la cloque créée lors d'une étape du procédé de fabrication selon l'invention, avant et après, une opération de traitement thermique ;
- la figure 5 illustre un résonateur de type FBAR réalisé selon le procédé de l'invention ;
- la figure 6 illustre la réponse électrique de la membrane non décollée du substrat (courbe 6a) et la réponse de la membrane suspendue (courbe 6b) ;

De manière générale le procédé de la présente invention permet de réaliser des composants à ondes acoustiques, par exemple des composants à ondes acoustiques de volume et notamment des composants de type résonateur FBAR comportant une membrane suspendue de matériau piézoélectrique avec une électrode inférieure et une électrode supérieure de manière à générer la propagation d'ondes acoustiques de volume, ladite membrane étant réalisée à la surface d'une cloque créée à partir de l'assemblage par collage de deux supports, l'un comportant à sa surface au moins une zone initiatrice de non collage, par exemple une nanostructure en saillie.

La membrane de matériau suspendue comprend une fine couche de matériau piézoélectrique. Le procédé pour réaliser une telle membrane peut se baser sur un procédé connu et maîtrisé comportant l'implantation d'un substrat massif de matériau piézoélectrique pour créer dans ce substrat une zone fragile enterrée délimitant dans ce substrat ladite fine couche puis la séparation de ladite fine couche de matériau piézoélectrique de l'ensemble du substrat piézoélectrique par fracture au niveau de cette zone fragile par exemple par traitement thermique éventuellement assisté de forces mécaniques.

### Exemple de réalisation

Un substrat piézoélectrique S_{Piezo} (par exemple de type LiNbO₃, LiTaO₃ ...) massif, est choisi pour l'application BAW (en terme d'orientation, de nature de matériau ...). Il pourrait s'agir en variante d'un substrat support (de silicium par exemple) présentant uniquement une couche superficielle de matériau piézoélectrique. Il comprend avantageusement un empilement d'au moins une couche métallique C_{M1} destinée à être une électrode enterrée pour le résonateur final. Cette couche métallique peut être à base de Cu, AlCu, AlSi, W, Mo, Pt, Cr ....

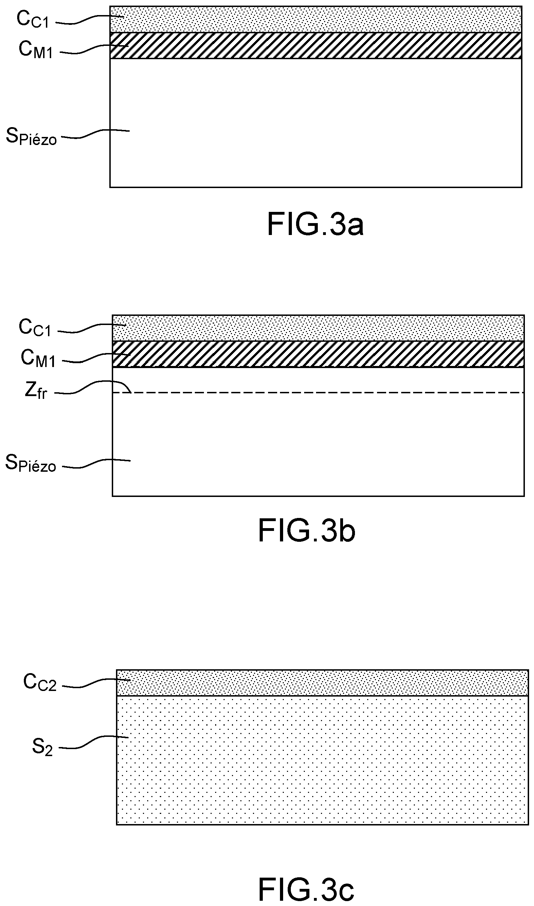

L'ensemble de l'empilement est ensuite éventuellement recouvert avec une couche de collage C_{C1}, il peut s'agir par exemple d'une couche diélectrique, par exemple de SiO₂ de quelques centaines de nm (par exemple 200 nm) en surface destinée à faciliter l'opération ultérieure de collage direct, comme illustré en figure 3a.

Une opération d'implantation ionique est réalisée (avant ou après le dépôt des couches métallique et de collage) dans le substrat massif piézoélectrique afin de créer une zone fragile enterrée Z_{fr} délimitant dans ce substrat la couche mince de matériau piézoélectrique à transférer. Cette implantation peut être effectuée par exemple à base d'hydrogène ou d'hélium ou un mélange de ces deux espèces avec des doses entre 10¹⁶ et 10¹⁷ at/cm² et ce avec une énergie comprise entre 50 keV et 250 keV selon l'épaisseur de la couche piézoélectrique choisie, comme illustré en figure 3b.

En parallèle on réalise sur un second substrat S₂ qui peut être en matériau piézoélectrique ou non, par exemple Si, Saphir, Quartz ..., le dépôt d'une couche de collage, par exemple diélectrique par exemple de SiO₂ en surface destinée à l'opération de collage, comme illustré en figure 3c. Il est à noter que cette couche peut être optionnelle et dépendante de la nature dudit second substrat.

Les substrats sont ensuite préparés, par exemple par polissage mécano-chimique, pour être compatible avec l'étape ultérieure de collage directe. Cette préparation peut permettre d'obtenir la planéité et la rugosité souhaitée pour le collage direct ultérieur.

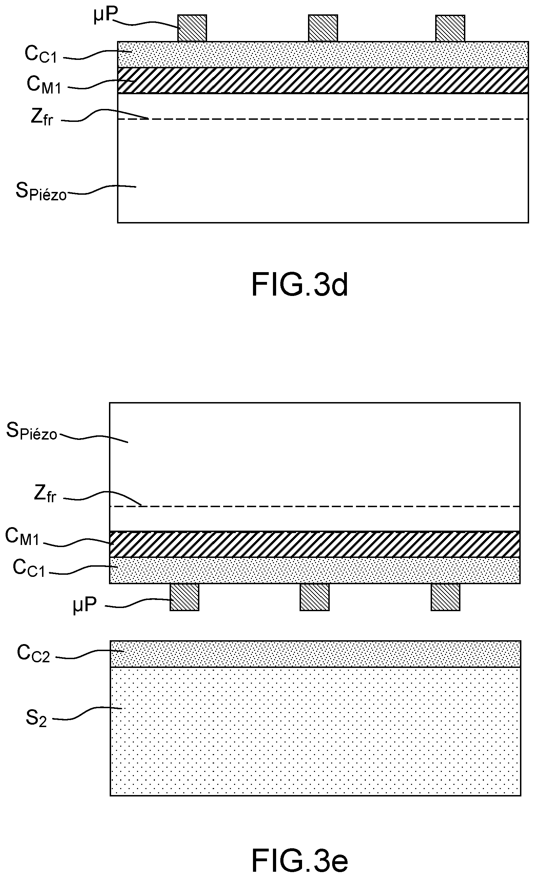

Durant/après cette étape, des particules de tailles maitrisées sont déposées/créées sur l'une des deux interfaces de collage. Ces particules ou µ-plots peuvent, par exemple, être créées par lithographie suivie d'une gravure ou encore par le dépôt de particules de taille contrôlée et de manière localisée. La figure 3d illustre une configuration dans laquelle les µ-plots µP, sont réalisés à la surface de la couche C_{C1}. Ces particules sont des zones initiatrices de non collage : elles empêchent localement le collage des deux substrats au niveau de ces zones et/ou autours de ces zones. D'autres types de zones initiatrices de non collage seront décrits ultérieurement.

La figure 3e illustre la mise en contact des deux empilements avant la phase de collage.

Les deux substrats sont ensuite collés par collage direct comme illustré dans l'article: Tong & Gösele 1999, Q.-Y. Tong, U. Gösele, Semiconductor Wafer Bonding: Science and Technology, Wiley, New York, 1999, 297 pp. Cet article décrit notamment le comportement d'une particule à l'interface de collage: en fonction de la taille de la particule (en particulier de sa hauteur), une cloque d'un rayon spécifique et d'égale hauteur à celle de la particule est formée.

Appliqué au cas du niobate de lithium (en termes de coefficient de déformation et énergie de surface correspondante au matériau), les ordres de grandeurs des rayons des cloques trouvés par calcul théorique et ceux trouvés expérimentalement sont en adéquation.

Dans le cas de la présente invention, la demanderesse a observé que la hauteur des bulles de gaz est nettement supérieure à la hauteur des particules : le diamètre et la hauteur des cloques sont contrôlés par le budget thermique appliqué.

Selon le procédé de la présente invention, un traitement thermique est appliqué (entre 100°C et 500°C, préférentiellement 250°C) afin d'initier le transfert du film mince de matériau piézoélectrique par fracture au niveau de la zone fragile enterré. Ce traitement thermique permet également de faire croitre la cloque initialement formée autour de la nanostructure en saillie. Sur les zones sans particules et hors des zones de cloques induites, le collage direct des faces est réalisé.

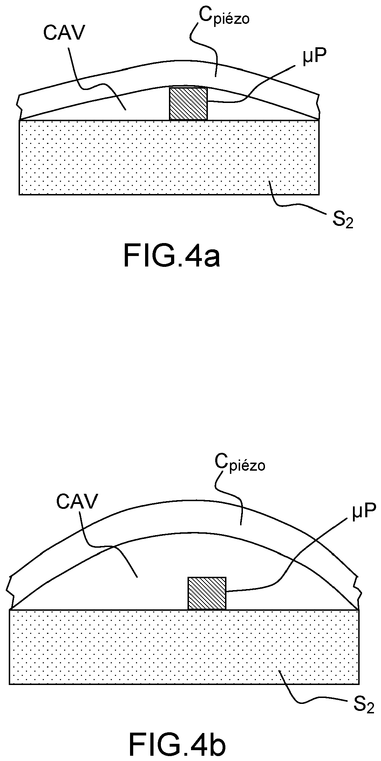

L'application d'un budget thermique supplémentaire (une fois la fracture obtenue) par exemple entre 100 et 500°C (préférentiellement autour de 250°C) permet de contrôler les dimensions latérales de cloques souhaitées. Il peut permettre également de décoller la membrane de la nanostructure en saillie (comme illustré figure 4b) ;

Ce budget thermique peut également permettre à deux ou plusieurs cloques contigües de se rejoindre pour former une cloque de grande dimension.

Une couche additionnelle d'encapsulation peut être déposée pour figer la structure. Les figures 4a et 4b schématisent (seule est représentée la couche de matériau piézoélectrique) ainsi la formation d'une cloque CAV au dessus d'une nanostructure µP, avant et après traitement thermique, conduisant à l'extension de ladite cloque.

Typiquement, pour des particules de l'ordre de 100 nm de hauteur, la cloque maximale atteinte est de l'ordre de 1000 µm de diamètre.

Des procédés de finition (tel que traitement thermique et/ou polissage pour obtenir une rugosité compatible avec la réalisation de composants a posteriori) peuvent être effectués.

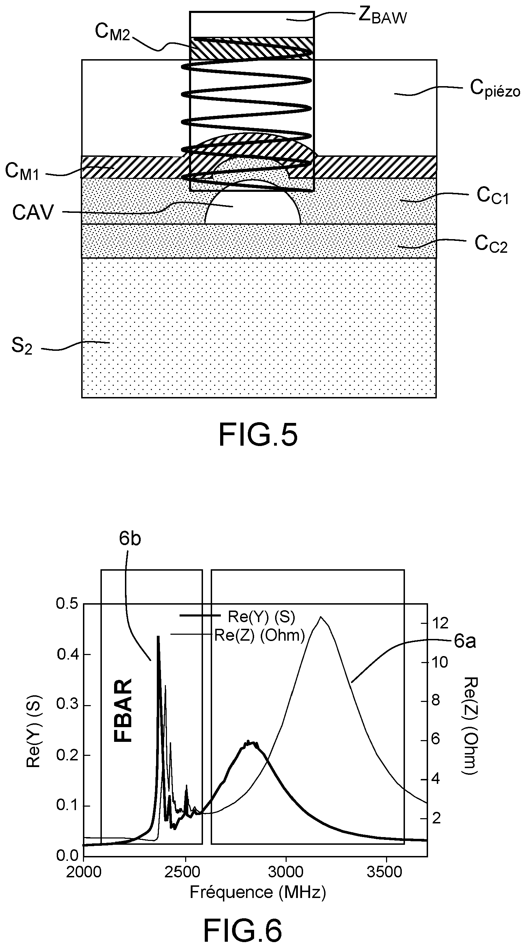

On obtient ainsi une couche fine de matériau piézoélectrique C_{Piézo} avec couches additionnelles sur un substrat hôte. Le résonateur FBAR final est réalisé par dépôt d'une électrode métallique supérieure C_{M2} au niveau de la cloque formée CAV, comme illustré en figure 5, mettant en évidence par ailleurs une zone Z_{BAW} de propagation d'ondes acoustiques de volume.

Des tests électriques ont été réalisés sur une telle structure montrant le caractère piézoélectrique résonant de la membrane suspendue. Les courbes de la figure 6 illustrent la réponse électrique de la membrane suspendue obtenue selon le procédé de l'invention. La courbe 6a correspond à la réponse de la couche piézoélectrique non décollée du substrat, la courbe 6b étant relative à ladite membrane décollée et donc à la structure finale du résonateur FBAR.

Comme évoqué précédemment, d'autres type de zones initiatrices de non collage peuvent être réalisées à la surface d'un ou des deux substrats à assembler pour prévenir localement le collage direct de ces deux substrats et générer ainsi à l'interface une cloque découplant acoustiquement localement ces deux substrats. Il peut s'agir notamment d'espèces hydrocarbures présentes en surface ou d'espèces liquides ou solides. Ces espèces peuvent générer des sous produits gazeux. Avec un traitement thermique adapté, cette zone est appelée à croitre en dimension par effet de pression dans la zone non collée, de façon à générer une zone de membrane suspendue (à tenue latérale). Pour les effets de dimensionnement on peut se rapporter aux articles de Tong et Goesele (book 1999 p.42).

Dans le cas d'un dégazage, l'article de F. Rieutord (ECS2010) donne par exemple la dimension rayon critique Rc de bulles (zones non collées) en fonction de la pression (traduire le nombre N de molécules ou d'atomes disponible) à une température donnée. Rc est une valeur où la bulle est stable à une température T donnée.

Lors du traitement thermique, la pression augmente comme PV= NRT. L'énergie de collage peut être augmentée lors de ce traitement thermique et pourtant elle n'est pas suffisante pour empêcher l'ouverture de la zone d'où l'augmentation des dimensions latérales r de la zone non collée et de sa hauteur h.

De plus si r est supérieur à un rayon critique tel que défini dans l'article de F. Rieutord (ECS 2010) ou Tong et Goesele (book 1999 p.42), la zone non collée ne se résorbe pas.

Ces contaminations contrôlées permettent d'induire des zones non collées supérieures à une taille critique.

Dans la réalisation, on peut déposer un contaminant pouvant dégazer sur la surface de la zone de collage par pointe AFM par exemple.

## Revendications

1. Procédé de fabrication d'un résonateur à ondes acoustiques comprenant une membrane suspendue comportant une couche de matériau piézoélectrique, **caractérisé en ce qu'**il comprend les étapes suivantes :
- la réalisation d'un premier empilement comportant au moins une couche de premier matériau piézoélectrique (C_{Piezo}) à la surface d'un premier substrat ;
- la réalisation d'un second empilement comprenant au moins un second substrat ;
- la réalisation d'au moins une zone initiatrice de non collage par dépôt ou création de particules de tailles maîtrisées à la surface d'un desdits empilements, la zone initiatrice de non collage ayant pour but d'empêcher localement le collage entre les deux empilements à son endroit ou son voisinage, laissant la surface d'un desdits empilements dotée localement de nanostructures en saillie dans ladite zone initiatrice de non-collage, avant une étape subséquente de collage ;
- le collage direct desdits deux empilements créant une cloque (CAV) entre la couche de premier matériau piézoélectrique et le second empilement, permettant le découplage acoustique local des deux empilements, due à la présence de la zone initiatrice de non collage ;
- l'amincissement du premier empilement pour éliminer au moins le premier substrat ;
ladite membrane étant réalisée à la surface de ladite cloque créée à partir de l'assemblage par collage des deux empilements.

2. Procédé de fabrication d'un résonateur à ondes acoustiques selon la revendication 1, **caractérisé en ce que** le collage direct est effectué par mise en contact direct des deuxdits empilements ou par thermocompression ou par collage anodique ou par collage par fusion.

3. Procédé de fabrication d'un résonateur à ondes acoustiques selon l'une des revendications 1 ou 2, **caractérisé en ce qu'**il comprend en outre une étape de traitement thermique réalisée pendant ou après l'étape de collage direct afin de favoriser la création et/ou la croissance de la cloque.

4. Procédé de fabrication d'un résonateur à ondes acoustiques selon l'une des revendications 1 à 3, **caractérisé en ce que** la zone initiatrice de non collage est une nanostructure en saillie correspondant à une excroissance locale par rapport à la surface desdits empilements de dimensions microniques.

5. Procédé de fabrication d'un résonateur à ondes acoustiques selon la revendication 4, **caractérisé en ce que** l'étape de réalisation de ladite nanostructure en saillie est effectuée par lithographie et gravure.

6. Procédé de fabrication d'un résonateur à ondes acoustiques selon la revendication 4, **caractérisé en ce que** l'étape de réalisation de ladite nanostructure en saillie est effectuée par le dépôt de particules de taille contrôlée et de manière localisée.

7. Procédé de fabrication d'un résonateur à ondes acoustiques selon l'une des revendications 4 à 6, **caractérisé en ce que** de ladite nanostructure en saillie présentant une hauteur de l'ordre de quelques dizaines à quelques centaines de nanomètres, la cloque présente une étendue de diamètre de l'ordre d'un millier de micromètres.

8. Procédé de fabrication d'un résonateur à ondes acoustiques selon l'une des revendications 4 à 7, **caractérisé en ce qu'**il comprend en outre une étape de préparation préalable au collage, de la surface entourant la nanostructure en saillie ou celle en regard, pour faciliter ou pour adapter l'extension de la cloque lors du traitement thermique, ladite étape de préparation consistant à diminuer l'hydrophilie et/ou à modifier la rugosité de la surface.

9. Procédé de fabrication d'un résonateur à ondes acoustiques selon la revendication 8, **caractérisé en ce que** l'étape de préparation pour diminuer l'hydrophilie est réalisée par un traitement plasma ou UV/ozone.

10. Procédé de fabrication d'un résonateur à ondes acoustiques selon la revendication 8, **caractérisé en ce que** l'étape de préparation consistant à modifier la rugosité est réalisée par gravure chimique, humide ou sèche.

11. Procédé de fabrication d'un résonateur à ondes acoustiques selon l'une des revendications 1 à 3, **caractérisé en ce que** la zone initiatrice de non collage est obtenue par le dépôt localisé d'hydrocarbures ou de produits liquides ou solides pouvant générer des sous-produits gazeux.

12. Procédé de fabrication d'un résonateur à ondes acoustiques selon la revendication 11, **caractérisé en ce que** le dépôt localisé d'hydrocarbures est effectué avec une pointe de microscope à force atomique.

13. Procédé de fabrication d'un résonateur à ondes acoustiques selon l'une des revendications précédentes, **caractérisé en ce que** le premier empilement et/ou le second empilement comportent en surface une couche de collage, au niveau de laquelle l'étape de collage subséquente est effectuée.

14. Procédé de fabrication d'un résonateur à ondes acoustiques selon l'une des revendications précédentes, **caractérisé en ce que** le premier empilement comporte entre la couche de premier matériau piézoélectrique et l'éventuelle couche de collage (ou la surface), une couche métallique destinée à servir d'électrode.

15. Procédé de fabrication d'un résonateur à ondes acoustiques selon l'une des revendications précédentes, **caractérisé en ce que** le premier matériau piézoélectrique est monocristallin.

16. Procédé de fabrication d'un résonateur à ondes acoustiques selon l'une des revendications précédentes, **caractérisé en ce qu'**il comporte en outre une étape d'implantation ionique de manière à créer dans le premier empilement une zone fragile enterrée délimitant avec la surface dudit empilement une zone comportant au moins en partie la couche de premier matériau piézoélectrique.

17. Procédé de fabrication d'un résonateur à ondes acoustiques selon la revendication 16, **caractérisé en ce que** l'amincissement est obtenu par fracture au niveau de la zone fragile enterrée.

18. Procédé de fabrication d'un résonateur à ondes acoustiques selon l'une des revendications précédentes, **caractérisé en ce que** l'amincissement est obtenu par polissage pouvant être de type mécano-chimique.

19. Procédé de fabrication d'un résonateur à ondes acoustiques selon l'une des revendications précédentes, **caractérisé en ce que** le matériau piézoélectrique est en Li (TaₓNb₁₋ₓ)O₃.

20. Procédé de fabrication d'un résonateur à ondes acoustiques selon l'une des revendications 1 à 15, **caractérisé en ce qu'**il comprend le dépôt d'une couche de matériau piézoélectrique en AIN ou PZT.

21. Procédé de fabrication d'un résonateur à ondes acoustiques selon l'une des revendications précédentes, **caractérisé en ce que** le second substrat est en silicium ou en quartz ou en diamant ou en saphir, ou en matériau composite comprenant l'un desdits matériaux.

22. Procédé de fabrication d'un résonateur à ondes acoustiques selon l'une des revendications précédentes, **caractérisé en ce qu'**au moins une couche de collage est en matériau diélectrique pouvant être en SiO₂.

23. Procédé de fabrication d'un résonateur à ondes acoustiques selon l'une des revendications précédentes, **caractérisé en ce qu'**il comporte en outre une étape de définition d'électrode dans une couche métallique.

24. Procédé de fabrication d'un résonateur à ondes acoustiques selon l'une des revendications précédentes, **caractérisé en ce qu'**il comprend en outre une étape de réalisation d'une électrode supérieure à la surface de l'empilement final des premier et second empilements, postérieure à l'étape d'amincissement.

## Patentansprüche

1. Verfahren zur Herstellung eines Schallwellenresonators, der eine aufgehängte Membran umfasst, die eine Schicht aus piezoelektrischem Material umfasst, **dadurch gekennzeichnet, dass** es die folgenden Schritte beinhaltet:
- Realisieren eines ersten Stapels, umfassend wenigstens eine Schicht aus einem ersten piezoelektrischen Material (C_{Piezo}) auf der Oberfläche eines ersten Substrats;
- Realisieren eines zweiten Stapels, umfassend wenigstens ein zweites Substrat;
- Realisieren wenigstens einer nichtklebenden Initiatorzone durch Absetzen oder Erzeugen von größenmäßig regulierten Partikeln auf der Oberfläche von einem der Stapel, wobei es Ziel der nichtklebenden Initiatorzone ist, ein Kleben zwischen den zwei Stapeln an ihrem Ort oder in ihrer Nähe lokal zu verhindern, so dass die Oberfläche von einem der Stapel, lokal dotiert mit in der nichtklebenden Initiatorzone überstehenden Nanostrukturen, vor einem nachfolgenden Klebeschritt freibleibt;
- direktes Kleben der beiden Stapel, um eine Blase (CAV) zwischen der Schicht aus dem ersten piezoelektrischen Material und dem zweiten Stapel zu erzeugen, so dass die beiden Stapel aufgrund der Anwesenheit der nichtklebenden Initiatorzone akustisch lokal abgekoppelt werden können;
- Verdünnen des ersten Stapels, um wenigstens das erste Substrat zu eliminieren;
wobei die Membran auf der Oberfläche der erzeugten Blase auf der Basis des Zusammenfügens der beiden Stapel durch Kleben realisiert wird.

2. Verfahren zur Herstellung eines Schallwellenresonators nach Anspruch 1, **dadurch gekennzeichnet, dass** das direkte Kleben durch direktes Inkontaktbringen der beiden Stapel oder durch Thermokompression oder durch anodisches Kleben oder durch Fusionskleben erfolgt.

3. Verfahren zur Herstellung eines Schallwellenresonators nach Anspruch 1 oder 2, **dadurch gekennzeichnet, dass** es ferner einen Schritt des Wärmebehandelns beinhaltet, realisiert während oder nach dem Schritt des direkten Klebens, um das Erzeugen und/oder Wachsen der Blase zu favorisieren.

4. Verfahren zur Herstellung eines Schallwellenresonators nach einem der Ansprüche 1 bis 3, **dadurch gekennzeichnet, dass** die nichtklebende Initiatorzone eine vorstehende Nanostruktur entsprechend einem lokalen Auswuchs mit Bezug auf die Oberfläche der Stapel mit mikronischen Abmessungen ist.

5. Verfahren zur Herstellung eines Schallwellenresonators nach Anspruch 4, **dadurch gekennzeichnet, dass** der Schritt des Realisierens der vorstehenden Nanostruktur durch Lithografie und Ätzen erfolgt.

6. Verfahren zur Herstellung eines Schallwellenresonators nach Anspruch 4, **dadurch gekennzeichnet, dass** der Schritt des Realisierens der vorstehenden Nanostruktur durch Absetzen von Partikeln geregelter Größe und auf lokalisierte Weise erfolgt.

7. Verfahren zur Herstellung eines Schallwellenresonators nach einem der Ansprüche 4 bis 6, **dadurch gekennzeichnet, dass** die vorstehende Nanostruktur eine Höhe in der Größenordnung von mehreren Dutzend bis zu mehreren hundert Nanometern hat, wobei die Blase einen Durchmesser in der Größenordnung von tausend Mikrometern aufweist.

8. Verfahren zur Herstellung eines Schallwellenresonators nach einem der Ansprüche 4 bis 7, **dadurch gekennzeichnet, dass** es ferner einen Schritt des Vorbereitens zum Kleben der Oberfläche beinhaltet, die die vorstehende Nanostruktur oder die gegenüber umgibt, um das Ausdehnen der Blase bei der Wärmebehandlung zu erleichtern oder zu adaptieren, wobei der Vorbereitungsschritt im Verringern der Hydrophilie und/oder im Modifizieren der Rauheit der Oberfläche besteht.

9. Verfahren zur Herstellung eines Schallwellenresonators nach Anspruch 8, **dadurch gekennzeichnet, dass** der Vorbereitungsschritt zum Verringern der Hydrophilie durch eine Plasma- oder UV/Ozon-Behandlung realisiert wird.

10. Verfahren zur Herstellung eines Schallwellenresonators nach Anspruch 8, **dadurch gekennzeichnet, dass** der Vorbereitungsschritt bestehend im Modifizieren der Rauheit durch chemisches, feuchtes oder trockenes Ätzen realisiert wird.

11. Verfahren zur Herstellung eines Schallwellenresonators nach einem der Ansprüche 1 bis 3, **dadurch gekennzeichnet, dass** die nichtklebende Initiatorzone durch lokalisiertes Absetzen von Kohlenwasserstoffen oder flüssigen oder festen Produkten erhalten wird, die gasförmige Nebenprodukte erzeugen können.

12. Verfahren zur Herstellung eines Schallwellenresonators nach Anspruch 11, **dadurch gekennzeichnet, dass** das lokalisierte Absetzen von Kohlenwasserstoffen mit einer Atomkraft-Mikroskopspitze erfolgt.

13. Verfahren zur Herstellung eines Schallwellenresonators nach einem der vorherigen Ansprüche, **dadurch gekennzeichnet, dass** der erste Stapel und/oder der zweite Stapel an der Oberfläche eine Klebstoffschicht umfasst/umfassen, an der der nachfolgende Klebeschritt erfolgt.

14. Verfahren zur Herstellung eines Schallwellenresonators nach einem der vorherigen Ansprüche, **dadurch gekennzeichnet, dass** der erste Stapel zwischen der Schicht aus erstem piezoelektrischem Material und der eventuellen Klebstoffschicht (oder der Oberfläche) eine zum Dienen als Elektrode bestimmte metallische Schicht umfasst.

15. Verfahren zur Herstellung eines Schallwellenresonators nach einem der vorherigen Ansprüche, **dadurch gekennzeichnet, dass** das erste piezoelektrische Material monokristallin ist.

16. Verfahren zur Herstellung eines Schallwellenresonators nach einem der vorherigen Ansprüche, **dadurch gekennzeichnet, dass** es ferner einen Ionenimplantationsschritt beinhaltet, um im ersten Stapel eine vergrabene zerbrechliche Zone zu erzeugen, die mit der Oberfläche des Stapels eine Zone begrenzt, die wenigstens teilweise die Schicht aus erstem piezoelektrischem Material umfasst.

17. Verfahren zur Herstellung eines Schallwellenresonators nach Anspruch 16, **dadurch gekennzeichnet, dass** die Verdünnung durch Fraktur an der vergrabenen zerbrechlichen Zone erzielt wird.

18. Verfahren zur Herstellung eines Schallwellenresonators nach einem der vorherigen Ansprüche, **dadurch gekennzeichnet, dass** die Verdünnung durch Polieren erzielt wird, das vom mechanochemischen Typ sein kann.

19. Verfahren zur Herstellung eines Schallwellenresonators nach einem der vorherigen Ansprüche, **dadurch gekennzeichnet, dass** das piezoelektrische Material Li(TaₓNb₁₋ₓ)O₃ ist.

20. Verfahren zur Herstellung eines Schallwellenresonators nach einem der Ansprüche 1 bis 15, **dadurch gekennzeichnet, dass** es das Absetzen einer piezoelektrischen Materialschicht aus AIN oder PZT umfasst.

21. Verfahren zur Herstellung eines Schallwellenresonators nach einem der vorherigen Ansprüche, **dadurch gekennzeichnet, dass** das zweite Substrat aus Silicium oder aus Quarz oder aus Diamant oder aus Saphir oder einem eines dieser Materialien umfassenden Verbundstoffs besteht.

22. Verfahren zur Herstellung eines Schallwellenresonators nach einem der vorherigen Ansprüche, **dadurch gekennzeichnet, dass** wenigstens eine Klebstoffschicht aus einem dielektrischen Material ist, das aus SiO₂ sein kann.

23. Verfahren zur Herstellung eines Schallwellenresonators nach einem der vorherigen Ansprüche, **dadurch gekennzeichnet, dass** es ferner einen Schritt des Definierens einer Elektrode in einer metallischen Schicht beinhaltet.

24. Verfahren zur Herstellung eines Schallwellenresonators nach einem der vorherigen Ansprüche, **dadurch gekennzeichnet, dass** es ferner einen Schritt des Realisierens einer oberen Elektrode an der Oberfläche des letzten Stapels aus erstem und zweitem Stapel nach dem Verdünnungsschritt beinhaltet.

## Claims

1. A process for fabricating an acoustic wave resonator comprising a suspended membrane comprising a piezoelectric material layer, and comprising the following steps:
- the production of a first stack comprising at least one layer of first piezoelectric material (C_{Piezo}) on the surface of a first substrate;
- the production of a second stack comprising at least one second substrate;
- the production of at least one non-bonding initiating zone by deposition or creation of particles of controlled sizes at the surface of one of said stacks, the non-bonding initiating zone for locally preventing bonding between both stacks in its place or its vicinity, leaving the surface of one of said stacks endowed locally with projecting nanostructures in the non-bonding initiating zone before a subsequent bonding step;
- the direct bonding of said two stacks creating a blister (CAV) between the layer of first piezoelectric material and the second stack, allowing for local acoustic decoupling of both stacks, due to the presence of the non-bonding initiating zone;
- the thinning of the first stack to eliminate at least the first substrate;
said membrane being produced at the surface of said blister created by bonding together the two stacks.

2. The process for fabricating an acoustic wave resonator according to claim 1, **characterized in that** direct bonding is performed by placing said two stacks in direct contact or by thermocompression or by anodic bonding or by fusion bonding.

3. The process for fabricating an acoustic wave resonator according to any one of claims 1 and 2, **characterized in that** it further comprises a heat treatment step carried out during or after the direct bonding step so as to promote the creation and/or the growth of the blister.

4. The process for fabricating an acoustic wave resonator according to any one of claims 1 to 3, **characterized in that** the non-bonding initiating zone is a projecting nanostructure corresponding to a local protuberance with respect to the surface of said stacks of micron dimensions.

5. The process for fabricating an acoustic wave resonator according to claim 4, **characterized in that** the step of producing said projecting nanostructure is performed by lithography and etching.

6. The process for fabricating an acoustic wave resonator according to claim 4, **characterized in that** the step of producing said projecting nanostructure is performed by the deposition of particles of controlled size in a localized manner.

7. The process for fabricating an acoustic wave resonator according to any one of claims 4 to 6, **characterized in that** said projecting nanostructure exhibiting a height of the order of a few tens of nanometers to a few hundred nanometers, the blister exhibits a diametral extent of the order of a thousand micrometers.

8. The process for fabricating an acoustic wave resonator according to any one of claims 4 to 7, **characterized in that** it further comprises a step of preparing, prior to the bonding, the surface surrounding the projecting nanostructure or that facing it, so as to facilitate or to adapt the extension of the blister during the heat treatment, said preparing step consisting in decreasing the hydrophily and/or in modifying the roughness of the surface.

9. The process for fabricating an acoustic wave resonator according to claim 8, **characterized in that** the preparing step for decreasing the hydrophily is carried out by a plasma or UV/ozone treatment.

10. The process for fabricating an acoustic wave resonator according to claim 8, **characterized in that** the preparing step consisting in modifying the roughness is carried out by chemical, wet or dry etching.

11. The process for fabricating an acoustic wave resonator according to any one of claims 1 to 3, **characterized in that** the non-bonding initiating zone is obtained by the localized deposition of hydrocarbons or of liquid or solid products that are able to generate gaseous by-products.

12. The process for fabricating an acoustic wave resonator according to claim 11, **characterized in that** the localized deposition of hydrocarbons is performed with an atomic force microscope tip.

13. The process for fabricating an acoustic wave resonator according to any of the preceding claims, **characterized in that** the first stack and/or the second stack comprise at the surface a bonding layer, at the level of which the subsequent bonding step is performed.

14. The process for fabricating an acoustic wave resonator according to any of the preceding claims, **characterized in that** the first stack comprises between the layer of first piezoelectric material and the optional bonding layer (or the surface), a metallic layer intended to serve as electrode.

15. The process for fabricating an acoustic wave resonator according to any of the preceding claims, **characterized in that** the first piezoelectric material is monocrystalline.

16. The process for fabricating an acoustic wave resonator according to any of the preceding claims, **characterized in that** it further comprises an ion implantation step so as to create in the first stack a buried fragile zone delimiting with the surface of said stack a zone comprising at least in part the layer of first piezoelectric material.

17. The process for fabricating an acoustic wave resonator according to claim 16, **characterized in that** the thinning is obtained by fracture at the level of the buried fragile zone.

18. The process for fabricating an acoustic wave resonator according to any of the preceding claims, **characterized in that** the thinning is obtained by polishing that may be of mechano-chemical type.

19. The process for fabricating an acoustic wave resonator according to any of the preceding claims , **characterized in that** the piezoelectric material is Li(TaₓNb₁₋ₓ)O₃.

20. The process for fabricating an acoustic wave resonator according to claims 1 to 15, **characterized in that** it comprises the deposition of a piezoelectric material layer of A1N or PZT.

21. The process for fabricating an acoustic wave resonator according to any of the preceding claims, **characterized in that** the second substrate is made of silicon or quartz or diamond or sapphire, or of composite material comprising one of said materials.

22. The process for fabricating an acoustic wave resonator according to any of the preceding claims, **characterized in that** at least one bonding layer is made of dielectric material that may be SiO₂.

23. The process for fabricating an acoustic wave resonator according to any of the preceding claims, **characterized in that** it further comprises a step of electrode definition in a metallic layer.

24. The process for fabricating an acoustic wave resonator according to any of the preceding claims, **characterized in that** it further comprises a step of producing an upper electrode on the surface of the final stack of the first and second stacks, subsequent to the thinning step.
